# EUROPÄISCHE PATENTANMELDUNG

(11) **EP 4 043 786 A1**
(43) Veröffentlichungstag der Anmeldung: **17.08.2022**
(21) Anmeldenummer: 22155620.2
(22) Anmeldetag: 08.02.2022
(51) Int. Cl.: F21V 29/508, H05K 7/20, F21V 23/02

(54) **ENERGIEVERSORGUNGSVORRICHTUNG FÜR EINE ELEKTRISCHE VORRICHTUNG, WIE Z.B. EINE FEUCHTRAUMLEUCHTE INSBESONDERE FÜR GEWÄCHSHÄUSER**

(30) Priorität: 10.02.2021 DE 102021103144
(71) Anmelder: Remus, Uwe, 50996 Köln (DE); Pfeiffer, Michael, 41751 Viersen (DE)
(72) Erfinder: Remus, Uwe, 50996 Köln (DE); Pfeiffer, Michael, 41751 Viersen (DE)
(74) Vertreter: dompatent von Kreisler Selting Werner - Partnerschaft von Patent- und Rechtsanwälten mbB

(57) **Zusammenfassung**

Die Energieversorgungsvorrichtung für eine elektrische Vorrichtung, wie z.B. eine Feuchtraumleuchte ist mit einer Energieversorgungseinheit (64) mit elektrischen und elektronischen Komponenten (83, 86, 87, 88, 89) versehen, die in einem Gehäuse (70) angeordnet sind. In dem Gehäuse (70) befinden sich ferner ein Verwirbelungslüfterrad (92) zur Verwirbelung von Luft in dem Gehäuse (70) und mindestens ein Abluftventilator (94) zum Abführen von Verwirbelungsluft aus dem Gehäuse (70).

## Beschreibung

Die Erfindung betrifft eine Energieversorgungsvorrichtung für eine elektrische Vorrichtung, wie z.B. eine Feuchtraumleuchte insbesondere für Gewächshäuser.

Für die unterschiedlichsten Anwendungen zum Betreiben elektrischer Vorrichtungen im gewerblichen oder privaten Bereich kann es von Vorteil sein, die Komponenten der Energieversorgungsvorrichtung in einem kleinformatigen Gehäuse und gegebenenfalls getrennt von der elektrischen Vorrichtung unterzubringen. Je höher die elektrischen Leistungen von Energieversorgungsvorrichtungen und je kleinformatiger deren Gehäuse sind, umso problematischer kann die Verlustwärmeabführung sein.

Aus CN-U-207588692, CN-A-111146958, CN-A-112135501 und CN-A-108551753 sind mit Zu- und Abluftventilatoren versehene Gehäuse bekannt, deren elektrische und elektronische Einrichtungen luftgekühlt sind.

Aufgabe der Erfindung ist es, bei einer Energieversorgungsvorrichtung für eine ausreichende Verlustwärmeabführung und damit Kühlung zu sorgen.

Zur Lösung dieser Aufgabe wird mit der Erfindung eine Energieversorgungsvorrichtung für eine elektrische Vorrichtung, wie z.B. eine Feuchtraumleuchte, insbesondere für Gewächshäuser, vorgeschlagen, die versehen ist mit
- einer Energieversorgungseinheit mit elektrischen und elektronischen Komponenten,
- einem Gehäuse, in dem die elektrischen und elektronischen Komponenten der Energieversorgungseinheit angeordnet sind, und
- einem in dem Gehäuse angeordneten Verwirbelungslüfterrad zur Verwirbelung von Luft in dem Gehäuse,
- wobei das Gehäuse mindestens einen Abluftventilator zum Abführen von Verwirbelungsluft aus dem Gehäuse aufweist.

Die Energieversorgungsvorrichtung weist ein Gehäuse auf, das getrennt von der elektrischen Vorrichtung ausgeführt ist, für deren Betrieb die Energieversorgungsvorrichtung vorgesehen ist. Bei diesem Gehäuse handelt es sich zweckmäßigerweise um ein leichtgewichtiges und tragbares sowie vornehmlich aufklappbares Gehäuse, für das beispielsweise im Handel erhältliche Werkzeugkoffer aus Kunststoff oder kleinformatige Präsentierkoffer für Gegenstände genutzt werden können. Das Gehäuse kann beispielsweise auf dem Boden oder an der Wand oder an anderen Gegenständen positioniert werden. Die Verlustwärmeabführung lässt sich in vorteilhafter Weise dadurch realisieren, dass in dem Gehäuse ein Lüfterrad angeordnet ist, das für eine Verwirbelung der Luft im Gehäuse führt. Die verwirbelte Luft wird dann zweckmäßigerweise über mindestens einen Abluftventilator nach außen abgeführt. Vorteilhafterweise kann auch für eine Zuluftführung gesorgt werden, was beispielsweise dadurch erfolgt, dass das Gehäuse mindestens eine Zuluftöffnung aufweist. Diese Zuluftöffnung kann, muss aber nicht, mit einem Ventilator versehen sein, um Luft in das Gehäuse einzubringen. Erfindungsgemäß ist das Gehäuse neben dem Abluftventilator und dem ggfs. vorliegenden Zuluftventilator zusätzlich mit dem Verwirbelungslüfterrad versehen, um nämlich den Luftstrom zwischen Zuluftöffnung und Abluftventilator zusätzlich zu verwirbeln. Damit erhöht sich der Luftkühlungseffekt.

Bei Ausbildung des Gehäuses der Energieversorgungs- und Steuereinheit als aufklappbare Box ist es ferner zweckmäßig, wenn die elektrischen und elektronischen Komponenten der Energieversorgungs- und Steuereinheit in dem Unterteil der aufklappbaren Box untergebracht sind, während sich in dem aufklappbaren Deckelteil an dessen Innenseite das Verwirbelungslüfterrad im Wesentlichen freiliegend befindet und darüber hinaus der mindestens eine Abluftventilator angeordnet ist.

Zweckmäßigerweise ist das Unterteil der Box mit einer Bodenwand und einer von dieser aufragenden Seitenwand versehen, wobei die mindestens eine Zuluftöffnung in der Seitenwand des Unterteils ausgebildet ist. Alternativ kann auch die Bodenwand mit der mindestens einen Zuluftöffnung versehen sein.

In weiterer zweckmäßiger Ausgestaltung der Erfindung kann vorgesehen sein, dass das Deckelteil und das Unterteil der Box jeweils einen Rand aufweisen, wobei diese Ränder im geschlossenen Zustand der Box einander benachbart und/oder aneinanderliegend angeordnet sind, und dass die mindestens eine Zuluftöffnung als Spalt zwischen den Rändern von Unterteil und Oberteil der Box oder als eine Aussparung in mindestens einem der Ränder von Unterteil und Oberteil der Box ausgebildet ist.

Die Erfindung wird nachfolgend anhand des Beispiels ihrer Anwendung bei einer Feuchtraumleuchte und unter Bezugnahme auf die Zeichnung näher erläutert. Im Einzelnen zeigen dabei:
- Fig. 1: eine perspektivische Ansicht auf die Feuchtraumleuchte gemäß einem Ausführungsbeispiel der Erfindung,
- Fig. 2: eine Draufsicht auf die Oberseite des Leuchtengehäuses der Fechtraumleuchte in Richtung des Pfeils II der Fig. 1,
- Fig. 3: eine Draufsicht ähnlich der wie in Fig. 2, jedoch ohne eingesetzte Lampenmodule zur Verdeutlichung der Auflageflächen für die Lampenmodule,
- Fig. 4: eine Seitenansicht eines Lampenmoduls in Explosionsdarstellung,
- Fig. 5: eine Vorderansicht auf ein Lampenmodul gemäß dem Pfeil V der Fig. 4,
- Fig. 6: eine perspektivische Ansicht auf die Oberseite des Leuchtengehäuses ohne Lampenmodule zur Verdeutlichung der spritzwassergeschützten Abdichtung des Leuchtengehäuses,
- Fig. 7: eine perspektivische Darstellung eines Zylinderrings, wie er jeweils zwischen den beiden Aufnahmeöffnungen eingesetzt ist, um das Leuchtengehäuse gegen Spritzwasser zu schützen,
- Fig. 8: eine perspektivische Darstellung der als Koffer ausgebildeten Box des Gehäuses für die Energieversorgungs- und Steuereinheit,
- Fig. 9: die Darstellung des Koffers gemäß Fig. 8 im aufgeklappten Zustand und
- Fig. 10: ein Blockschaltbild der Verschaltung der Komponenten der Energieversorgungs- und Steuereinheit.

Bevor nachfolgend auf die einzelnen Merkmale des Ausführungsbeispiels der erfindungsgemäßen Energieversorgungsvorrichtung eingegangen wird, wird als Anwendungsbeispiel ein modulares Feuchtraumleuchtensystem beschrieben, bei dem die erfindungsgemäße Energieversorgungsvorrichtung eingesetzt werden kann.

Neben der eigentlichen Energieversorgung für die jeweilige elektrische Vorrichtung kann die erfindungsgemäße Vorrichtung Komponenten für die Steuerung der jeweiligen elektrischen Vorrichtung enthalten, wie es vorteilhafterweise bei dem hier beschriebenen Anwendungsbeispiel des Einsatzes der erfindungsgemäßen Energieversorgungsvorrichtung bei einem Feuchtraumleuchtensystem der Fall ist.

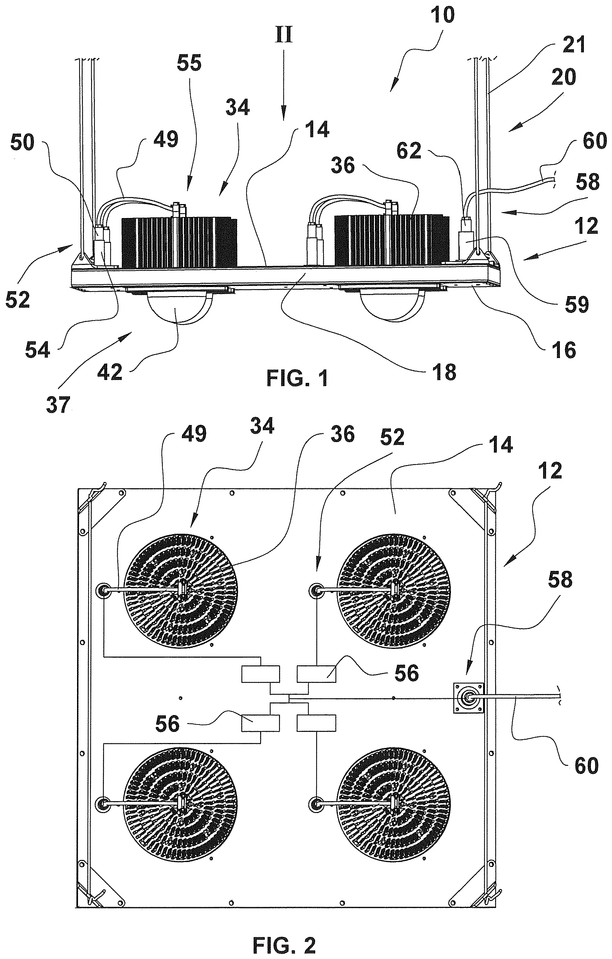

In den Fign. 1 bis 3 sowie 5 ist eine Feuchtraumleuchte 10 gezeigt, die ein vergleichsweise flaches und in diesem Ausführungsbeispiel quadratisches Leuchtengehäuse 12 aus beispielsweise Metall aufweist. Das Leuchtengehäuse 12 weist eine plattenförmige Oberseiten-Gehäusewand 14 und eine ebenfalls als Platte ausgebildete Unterseiten-Gehäusewand 16 auf, zwischen denen sich eine umlaufende Gehäuseseitenwand 18 aus z.B. vier auf Gehrung ausgebildeten Segmenten befindet. Diese drei Komponenten sind spritzwassergeschützt miteinander verbunden, beispielsweise miteinander verschraubt, wobei zusätzlich noch eine Verklebung der Komponenten vorgesehen ist. Alternativ können zwischen den beiden Gehäusewänden und der Gehäuseseitenwand elastische Dichtelemente angeordnet sein. Das Leuchtengehäuse 12 hängt in diesem Ausführungsbeispiel an Strangelementen 20 in Form von Bändern oder Seilen 21 von einer Decken- oder anderen Haltekonstruktion herab.

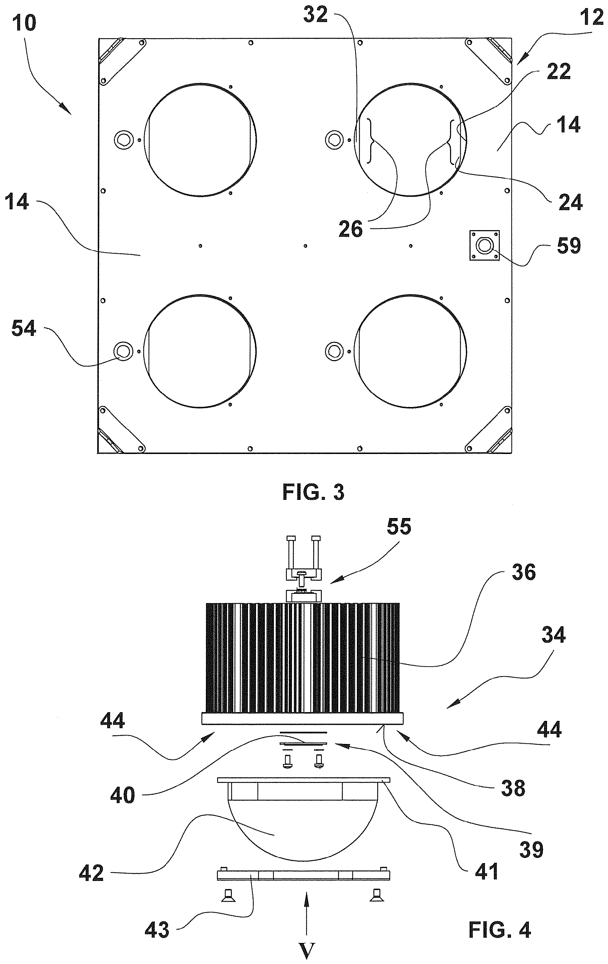

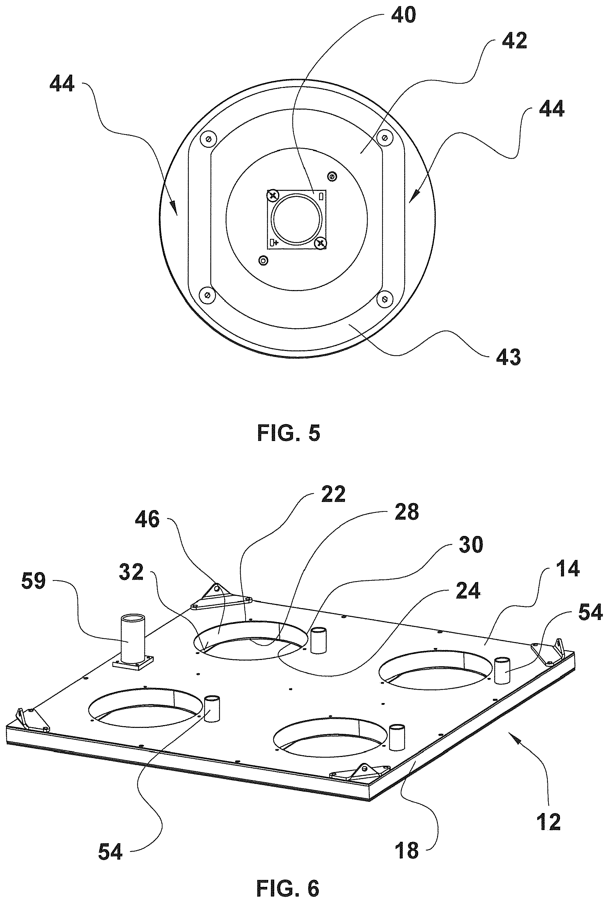

Wie insbesondere anhand der Fign. 3 und 6 zu erkennen ist, weist das Leuchtengehäuse 12 in diesem Ausführungsbeispiel vier Paare von miteinander fluchtenden Aufnahmeöffnungen 22, 24 auf. Die Aufnahmeöffnungen 22 befinden sich in der Oberseiten-Gehäusewand 14 und sind in diesem Ausführungsbeispiel kreisrund. Fluchtend mit jeder Aufnahmeöffnung 22 der Oberseiten-Gehäusewand 14 ist eine Aufnahmeöffnung 24 in der Unterseiten-Gehäusewand 16 ausgebildet. Die Aufnahmeöffnungen 24 weisen jeweils zwei Öffnungsrandabschnitte 26 auf, innerhalb derer der Öffnungsrand 28 einer Aufnahmeöffnung 24 der Unterseiten-Gehäusewand 16 über den Öffnungsrand 30 der zugehörigen Aufnahmeöffnung 22 der Oberseiten-Gehäusewand 14 vorsteht. Die Öffnungsrandabschnitte 26 bilden somit Auflageflächen 32, auf denen jeweils ein Lampenmodul 34 ruht, welches in das Paar von Aufnahmeöffnungen 22, 24 eingesetzt ist.

In den Fign. 1 und 2 sind vier solche Lampenmodule 34 gezeigt. Das Lampenmodul 34 ist darüber hinaus in Seitenansicht und in Explosionsdarstellung in Fig. 4 und in Vorderansicht in Fig. 5 gezeigt. Es weist gemäß Fig. 4 einen zylindrischen Kühlkörper 36 auf, der eine Montagefläche 38 aufweist, von der in an sich bekannter Weise Kühlfahnen radial abstehen. An der Montagefläche 38 befindet sich thermisch gut angebunden eine Lichtquelle 39 in Form eines LED-(COB-)Chips 40, der eine Vielzahl von LEDs aufweist. An der Montagefläche 38 liegt darüber hinaus ein optisches Element 37 in Form einer optischen Linse 42 an. Das von dem LED-Chip 40 abgegebene Licht gelangt direkt in die optische Linse 42, durch die es in einem durch die Beschaffenheit und Geometrie der optischen Linse 42 definierten Abstrahlwinkel im Raum abgestrahlt wird. Die Linse 42 weist einen Dichtflansch 41 auf, der von einem an seiner Außenseite ovalen Halter 43 umgriffen ist, der mit dem Kühlkörper 36 z.B. durch Verschraubung verbunden ist und durch den die Linse 42 gegen den Kühlkörper 36 geklemmt gehalten sowie der Bereich zwischen der Linse 42 und dem Kühlkörper 36 um den LED-Chip 40 herum spritzwassergeschützt ist. Wie anhand von Fig. 5 zu erkennen ist, befinden sich an der Vorderseite jedes Lampenmoduls 34, d.h. an der Montagefläche 38 des Kühlkörpers 36 jedes Lampenmoduls 34 außerhalb des Linsenhalters 43 zwei diametral gegenüberliegende Abstützflächen 44, die bei in ein Aufnahmeöffnungspaar eingesetztem Lampenmodul 34 auf den Auflageflächen 32 aufliegen und somit ein "Durchfallen" der Lampenmodule 34 durch die Paare von Aufnahmeöffnungen verhindern.

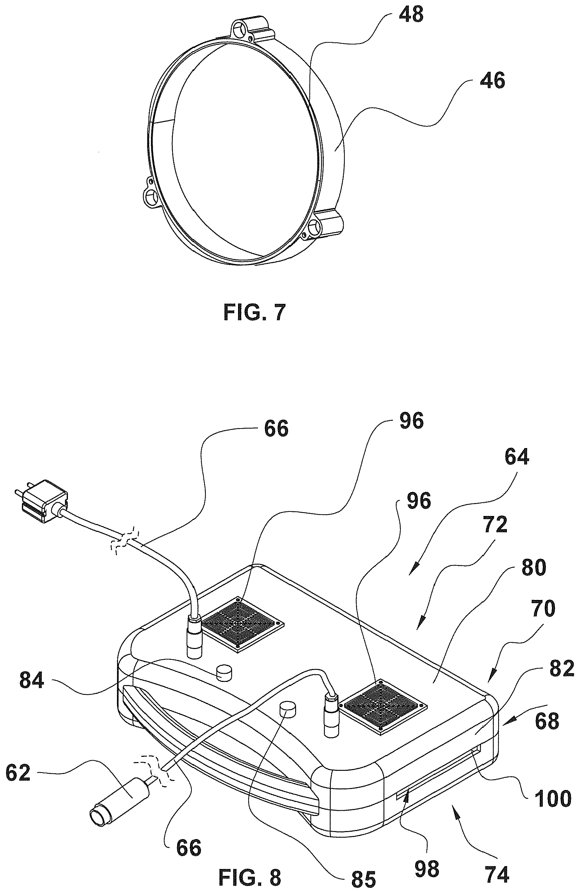

Wie anhand von Fig. 6 zu erkennen ist, ist der Zwischenraum zwischen den beiden Aufnahmeöffnungen 22 und 24 eines jeden Paars von Aufnahmeöffnungen durch einen Zylinderring 46 überbrückt, der perspektivisch in Fig. 7 gezeigt ist. Die axiale Höhe dieses Zylinderrings 46 ist gleich der Höhe des Leuchtengehäuses 12. Der Zylinderring 46 weist an seinen stirnseitigen Schmalenden elastische Dichtringe 48 auf, die z.B. in Nuten des Zylinderrings 46 eingesetzt sind und die der spritzwassergeschützten Abdichtung des Zylinderrings 46 zu den Öffnungsrändern 28, 30 der beiden Aufnahmeöffnungen 22, 24 dienen. Jeder Zylinderring 46 ist durch Verschraubung am Leuchtengehäuse 12 befestigt, und zwar manipulationssicher.

Wie insbesondere anhand von Fign. 1 und 2 zu erkennen ist, ist jedes Lampenmodul 34 mit einem Anschlusskabel 49 versehen, an dessen Ende sich der Stecker 50 eines Lampenmodul-Verbinders 52 befindet, der ferner eine Steckerbuchse 54 aufweist, die an der Oberseiten-Gehäusewand 14 nach oben abstehend angeordnet ist. Am hinteren Ende des Kühlkörpers 36 befindet sich eine Klemme 55 als Zugentlastung für das Anschlusskabel 49 (siehe auch Fig. 4). Innerhalb des Leuchtengehäuses 12 befindet sich pro Lampenmodul 34 ein Gleichspannungswandler 56, wobei die Gleichspannungswandler 56 elektrisch mit jeweils einer anderen der Steckerbuchsen 54 verbunden sind. Die Gleichspannungswandler 56 sind ihrerseits mit einem Zuleitungsverbinder 58 verbunden, der ein an der Oberseiten-Gehäusewand 14 angeordnetes Steckerteil 59 aufweist, und zwar für den Anschluss einer Zu-/Steuerleitung 60 einer Energieversorgungs- und Steuereinheit 64, wobei die Zu-/Steuerleitung 60 das Steckerbuchsenteil 62 des Zuleitungs(-steck-)verbinders 58 aufweist.

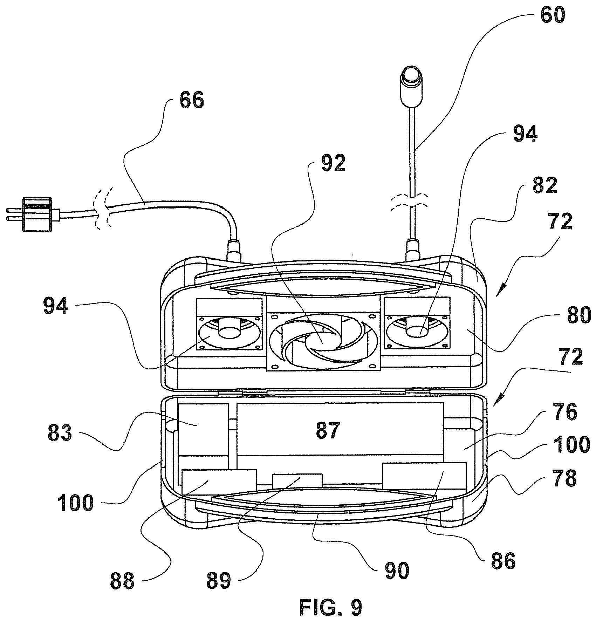

Außerhalb des Leuchtengehäuses 12 befindet sich die Energieversorgungsund Steuereinheit 64 (d.h. das Vorschaltgerät) für die Lampenmodule 34, die über ein Netzkabel 66 an das allgemeine Energieversorgungsnetz anschließbar ist und ihrerseits über die Zu-/Steuerleitung 60 mit dem Leuchtengehäuse 12 verbindbar ist. Die Energieversorgungs- und Steuereinheit 64 weist einen aufklappbaren Koffer 68 als Box oder Gehäuse 70 auf, der ein Oberteil 72 und ein Unterteil 74 aufweist. Das Unterteil 74 umfasst eine Bodenwand 76 (siehe die Fign. 8 und 9) und eine umlaufende Seitenwand 78, die von der Bodenwand 76 aufragt. Auch das Oberteil 72 weist eine Deckelwand 80 mit von dieser aufragenden umlaufenden Seitenwand 82 auf.

In dem Unterteil 74 befinden sich elektrische und elektronische Komponenten der Energieversorgungs- und Steuereinheit 64, bei denen es sich um einen AC/DC-Spannungswandler 83, ein Zwei-Kanal-Relais 88, einen Niederspannungstreiber 87 mit AC/DC-Wandler, eine Lüftersteuerung 86 und eine Bluetooth-Steuerung 89 handelt. Diese Komponenten erzeugen im Betrieb Verlustwärme, die aus dem Koffer 68 abgeführt werden muss. Der Koffer 68 besteht typischerweise aus Kunststoff und weist z.B. einen zweigeteilten Haltegriff 90 auf. Um die Verlustwärme abzuführen, weist der Koffer 68 an der Innenseite seiner Deckelwand 80 ein Lüfterrad 92 auf, das innerhalb des Koffers 68 für Luftverwirbelung sorgt. Die auf diese Weise verwirbelte Luft wird über in diesem Ausführungsbeispiel zwei Abluftventilatoren 94 nach außen abgeführt. Die in der Deckelwand 80 befindlichen Öffnungen dieser beiden Abluftventilatoren 94 sind mit Gittern 96 versehen.

Als Zuluftführung zum Innern des Koffers 68 dienen ein oder mehrere Zuluftöffnungen 98, die als Randaussparung(en) 100 in der Seitenwand 78 des Unterteils 74 ausgebildet sind. Je nach Ausgestaltung des Koffers 68 kann auf eine solche Konstruktion für die Luftzufuhr verzichtet werden, und zwar vornehmlich dann, wenn der Koffer 68 nicht dicht schließt, so dass bei geschlossenem Koffer 68 durch den durch die Abluftventilatoren 94 erzeugten Unterdruck im Innern des Koffers 68 dennoch Luft über den wenn auch recht schmalen Spalt zwischen Oberteil 72 und Unterteil 74 des Koffers 68 angesaugt wird.

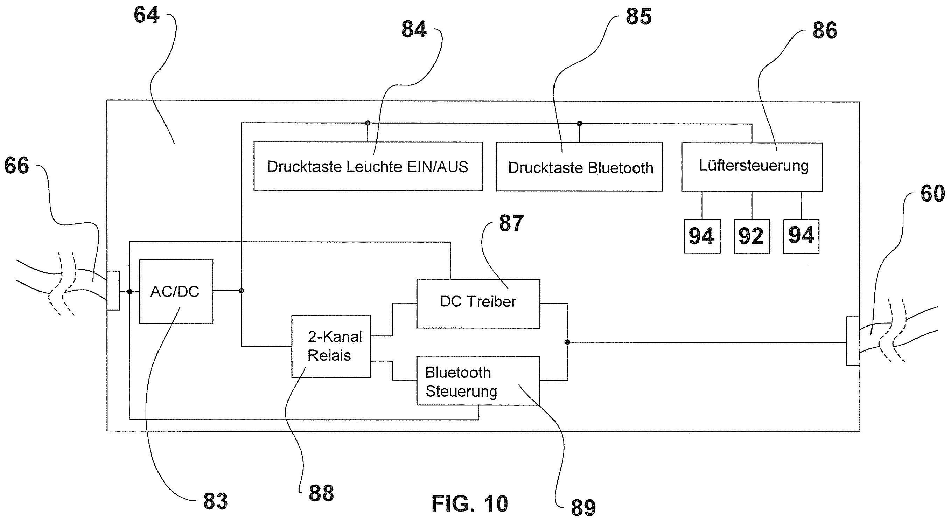

In Fig. 10 sind die Hauptkomponenten der Energieversorgungs- und Steuereinheit 64 als Blockschaltbild gezeigt. Ein Spannungswandler 83 wandelt die Netzspannung von typischerweise 220 Volt in die interne Betriebsspannung von beispielsweise 12 V DC für einige der Komponenten der Energieversorgungs- und Steuereinheit 64. Mit dieser Betriebsspannung werden zwei beleuchtete Drucktaster, nämlich die EIN/AUS-Drucktaste 84 und eine weitere Drucktaste 85 zur wahlweisen Aktivierung einer Bluetooth-Steuerung betrieben, die, wie in Fig. 8 gezeigt, am Oberteil 72 des Koffers 68 angeordnet sind. Ferner können noch Gerätschutzschalter für die Primärseite des Vorschaltgeräts und dessen Sekundärseite, d.h. für die Lampenmodule 34 vorgesehen sein. Als weitere Komponente weist die Energieversorgungs- und Steuereinheit 64 eine Lüftersteuerung 86 auf, die beispielsweise das Lüfterrad 92 sowie die beiden Abluftventilatoren 94 temperaturabhängig steuert und in dem Oberteil 80 (aber ebenso gut auch im Unterteil 74) des Koffers 68 untergebracht sein kann.

Ferner weist die Energieversorgungs- und Steuereinheit 64 einen Niederspannungstreiber 87 mit AC/DC-Wandler für die Gleichspannung zum Betrieb der Lampenmodule 34 auf, der bei Betätigung der Drucktaste 84 über ein mit der Betriebsspannung von z.B. 12 V DC betriebenes Zwei-Kanal-Relais 88 angesteuert wird. Bei aktivierter Bluetooth-Steuerung (Drucktaste 85) kann die Feuchtraumleuchte 10 über eine App eines beispielsweise Smartphone gesteuert werden. Hierzu dient ein Bluetooth-Steuerungsbauteil 89. Die gesamten elektrischen/elektronischen Komponenten im Unterteil 74 des Koffers 68 sind auf einer Montageplatte vormontiert und miteinander verdrahtet, so dass die Montageplatte als Einheit in das Unterteil 74 des Koffers 68 eingesetzt und in diesem montiert werden kann.

### BEZUGSZEICHENLISTE

- 10: Feuchtraumleuchte
- 12: Leuchtengehäuse
- 14: Oberseiten-Gehäusewand
- 16: Unterseiten-Gehäusewand
- 18: Gehäuseseitenwand
- 20: Strangelement
- 21: Seil
- 22: Aufnahmeöffnungen in der Oberseiten-Gehäusewand
- 24: Aufnahmeöffnungen in der Unterseiten-Gehäusewand
- 26: Öffnungsrandabschnitte
- 28: Öffnungsrand einer Aufnahmeöffnung in der Oberseiten-Gehäusewand
- 30: Öffnungsrand einer Aufnahmeöffnung in der Unterseiten-Gehäusewand
- 32: Auflageflächen
- 34: Lampenmodul
- 36: Kühlkörper
- 37: optisches Element
- 38: Montagefläche
- 39: Lichtquelle
- 40: LED-Chip
- 41: Dichtflansch der Linse
- 42: Linse
- 43: Linsenhalter
- 44: Abstützflächen
- 46: Zylinderring
- 48: Dichtring des Zylinderrings
- 49: Anschlusskabel
- 50: Steckverbinder-Steckerteil
- 52: Lampenmodul-Verbinder (Steckverbinder)
- 54: Steckerverbinder-Buchsenteil
- 55: Zugentlastungsklemme
- 56: Gleichspannungswandler
- 58: Zuleitungsverbinder (Steckverbinder)
- 59: Steckverbinder-Steckerteil
- 60: Zu-/Steuerleitung
- 62: Steckverbinder-Buchsenteil
- 64: Energieversorgungs- und Steuereinheit (Vorschaltgerät)
- 66: Netzkabel
- 68: Koffer
- 70: Gehäuse der Energieversorgungs- und Steuereinheit
- 72: Oberteil des Koffers
- 74: Unterteil des Koffers
- 76: Bodenwand des Unterteils
- 78: Seitenwand des Unterteils
- 80: Deckelwand des Oberteils
- 82: Seitenwand des Oberteils
- 83: AC/DC-Spannungswandler
- 84: EIN/AUS-Drucktaste
- 85: Bluetooth-Drucktaste
- 86: Lüftersteuerung
- 87: Niederspannungstreiber mit AC/DC-Wandler
- 88: Zwei-Kanal-Relais
- 89: Bluetooth-Steuerungsbauteil
- 90: Haltegriff
- 92: Verwirbelungslüfterrad
- 94: Abluftventilator
- 96: Gitter
- 98: Zuluftöffnung
- 100: Randaussparung der Seitenwand des Unter- und/oder Oberteils des Koffers

## Patentansprüche

1. Energieversorgungsvorrichtung für eine elektrische Vorrichtung, wie z.B. eine Feuchtraumleuchte, insbesondere für Gewächshäuser, mit
- einer Energieversorgungseinheit (64) mit elektrischen und elektronischen Komponenten (83, 86, 87, 88, 89),
- einem Gehäuse (70), in dem die elektrischen und elektronischen Komponenten (83, 86, 87, 88, 89) der Energieversorgungseinheit (64) angeordnet sind, und
- einem in dem Gehäuse (70) angeordneten Verwirbelungslüfterrad (92) zur Verwirbelung von Luft in dem Gehäuse (70),
- wobei das Gehäuse (70) mindestens einen Abluftventilator (94) zum Abführen von Verwirbelungsluft aus dem Gehäuse (70) aufweist.

2. Energieversorgungsvorrichtung nach Anspruch 1, **dadurch gekennzeichnet, dass** das Gehäuse (70) der Energieversorgungseinheit (64) als aufklappbare und insbesondere als tragbare aufklappbare Box mit einem Oberteil (72) und einem Unterteil (74) ausgebildet ist, dass die Energieversorgungseinheit (64) elektrische und elektronische Komponenten (83, 86, 87, 88, 89) aufweist, die in dem Unterteil (74) der Box untergebracht sind, und dass das Verwirbelungslüfterrad (92) und der mindestens eine Abluftventilator (94) an der Innenseite des Oberteils (72) der Box angeordnet sind.

3. Energieversorgungsvorrichtung nach einem der Ansprüche 1 oder 2, **dadurch gekennzeichnet, dass** die Box mindestens eine Zuluftöffnung (98) aufweist.

4. Energieversorgungsvorrichtung nach Anspruch 3, **dadurch gekennzeichnet, dass** die mindestens eine Zuluftöffnung (98) in dem Unterteil (74) der Box ausgebildet ist.

5. Energieversorgungsvorrichtung nach Anspruch 4, **dadurch gekennzeichnet, dass** das Unterteil (74) der Box eine Bodenwand (76) und eine von dieser aufragende Seitenwand (78) aufweist und dass die mindestens eine Zuluftöffnung (98) in der Seitenwand (78) des Unterteils (74) ausgebildet ist.

6. Energieversorgungsvorrichtung nach Anspruch 4, **dadurch gekennzeichnet, dass** das Oberteil (72) und das Unterteil (74) der Box jeweils einen Rand aufweisen, wobei diese Ränder im geschlossenen Zustand der Box einander benachbart und/oder aneinanderliegend angeordnet sind, und dass die mindestens eine Zuluftöffnung (98) als Spalt zwischen den Rändern von Unterteil (74) und Oberteil (72) der Box oder als eine Aussparung (100) in mindestens einem der Ränder von Unterteil (74) und Oberteil (72) der Box ausgebildet ist.
